**Europäisches Patentamt**

**European Patent Office**

**Office européen des brevets**

(19)

(11) Veröffentlichungsnummer : **0 167 606**
**B1**

(12) **EUROPÄISCHE PATENTSCHRIFT**

(45) Veröffentlichungstag der Patentschrift :
23.12.87

(21) Anmeldenummer : 85900632.2

(22) Anmeldetag : 11.01.85

(86) Internationale Anmeldenummer :
PCT/DE 85/00005

(87) Internationale Veröffentlichungsnummer :
WO/8503120 (18.07.85 Gazette 85/16)

(51) Int. Cl.⁴ : **G 01 B  7/06**

(54) VORRICHTUNG ZUR KONTINUIERLICHEN MESSUNG DER DICKE.

(30) Priorität : 14.01.84 DE 3401140

(43) Veröffentlichungstag der Anmeldung :
15.01.86 Patentblatt 86/03

(45) Bekanntmachung des Hinweises auf die Patenterteilung : 23.12.87 Patentblatt 87/52

(84) Benannte Vertragsstaaten :
AT BE CH DE FR GB LI LU NL SE

(56) Entgegenhaltungen :
DE-B- 1 017 372
GB-A- 2 013 352
GB-A- 2 080 532
US-A- 3 278 843
US-A- 3 775 277

(73) Patentinhaber : FRAUNHOFER-GESELLSCHAFT ZUR
FÖRDERUNG DER ANGEWANDTEN FORSCHUNG
E.V.
Leonrodstrasse 54
D-8000 München 19 (DE)

(72) Erfinder : NESKE, Eugen
Auwaldstrasse 37
D-7800 Freiburg (DE)
Erfinder : BERGMANN, Eckhard
Engesserstrasse 1a
D-7800 Freiburg (DE)
Erfinder : BACHEM, Karl-Heinz, Dr
Keltenring 91
D-7815 Kirchzarten (DE)
Erfinder : KULMUS, Karl
Alemannenstrasse 7
D-7801 March 1 (DE)

(74) Vertreter : Rackette, Karl, Dipl.-Phys. Dr.-Ing
Kaiser-Joseph-Strasse 179 Postfach 1310
D-7800 Freiburg (DE)

**Beschreibung**

Die Erfindung betrifft eine Vorrichtung zur kontinuierlichen Messung der Dicke eines mit Hilfe einer Beschichtungsanlage auf einem Trägermaterial erzeugten Materialniederschlags durch Bestimmung der Ablagerungsdicke auf einer mit dem Eingang eines Auswerteschaltkreises gekoppelten, zwei felderzeugende Elektroden aufweisenden Referenzsonde, die in einer Beschichtungsanlage in der Nähe des Trägermaterials in einem Gehäuse mit wenigstens einer als Blendenöffnung dienenden Einlaßöffnung angeordnet und mit einer Wechselspannung beaufschlagt ist.

Bei einer solchen aus der DE-OS 31 20 443 bekannten Vorrichtung wird ein Schwingquarzmeßkopf eingesetzt, bei dem die beiden felderzeugenden Elektroden, auf zwei Flächen eines Schwingquarzes aufgebracht sind und bei einer Beaufschlagung mit einer Wechselspannung ein Wechselfeld in der Weise erzeugen, daß der Schwingquarz zum Schwingen angeregt wird und die Frequenz einer Oszillatorschaltung des Auswerteschaltkreises festlegt. Die Resonanzfrequenz des Schwingquarzes hängt von der sich im Laufe der Beschichtung ändernden Schichtmasse ab, so daß durch Auswerten der Frequenzänderung bei einer Beschichtung eine Bestimmung der Ablagerungsdicke möglich ist. Um die Dickenmessungen einigermaßen genau zu machen, ist die auswertbare Frequenzänderung auf eine Änderung von wenigen Prozent beschränkt. Weiterhin ist die bekannte Vorrichtung für Schichtdicken im Bereich von einigen Mikrometern bzw. Flußraten von einigen Mikrometern pro Sekunde nicht geeignet, da die Empfindlichkeit mit zunehmender Quarzbeschichtung stark abnimmt. Aus diesem Grunde wird eine Quarzwechselvorrichtung verwendet, um dadurch die bei der Schwingquarztechnik nicht vermeidbaren Ermüdungserscheinungen zu umgehen.

Bei einer aus der DE-AS 29 23 066 bekannten Vorrichtung zur Schichtdickenmessung von elektrisch nichtleitenden Schichten auf elektrisch leitendem Material nach dem Wirbelstromverfahren erfolgt das Aufsetzen einer Prüfspule nach Abschluß der Beschichtung. Eine Überwachung des gerade ablaufenden Beschichtungsprozesses ist somit nicht möglich.

In der DE-AS 10 17 372 ist ein Dickenmeßgerät beschrieben, das ebenfalls Wirbelstromeffekte und somit eine induktive Methode ausnutzt. Das Dickenmeßgerät verfügt über eine Prüfspule, die mit einem über die Belastung der Prüfspule dämpfbaren Schwingkreis gekoppelt ist. Die Prüfspule ist mit einem in seiner Frequenz gewobbelten Schwingkreis verbunden und erzeugt in Abhängigkeit von der Betriebsfrequenz des Oszillators mehr oder weniger weit in das Schichtmaterial eindringende Wirbelströme. Beim Durchstimmen des Oszillators ist die Induktion der höherfrequenten Ströme mit einer geringeren Eindringtiefe verbunden als bei den niedrigeren Frequenzen.

Aus diesem Grunde erhöht sich die Belastung des Oszillators mit der Abnahme der Frequenz bis die Schwingungen des Oszillators schließlich abreißen, wobei die Frequenz, bei der dies geschieht, ein Maß für die Beschichtungsdicke ist.

Der Erfindung liegt die Aufgabe zugrunde, eine Vorrichtung der eingangs genannten Art zu schaffen, die über einen großen Dickenbereich genaue Messungen kontinuierlich gestattet.

Diese Aufgabe wird erfindungsgemäß dadurch gelöst, daß die Referenzsonde eine das auszuwertende Signal auskoppelnde, im Feld der beiden felderzeugenden Elektroden angeordnete starre Meßelektrode aufweist und daß die zwei felderzeugenden Elektroden mit gegeneinander um 180° phasenverschobenen Wechselspannungen beaufschlagt sind, deren Amplituden wenigstens bei Meßbeginn durch den im Auswerteschaltkreis enthaltenen Ansteuerteil für die felderzeugenden Elektroden so einstellbar sind, daß die in der Meßelektrode durch die beiden felderzeugenden Elektroden bewirkten Ströme gegenseitig kompensiert sind.

Durch die mit gegenphasigen Wechselspannungen beaufschlagten Elektroden werden in der Meßelektrode Ströme erzeugt, die sich im abgeglichenen Zustand völlig kompensieren. Wenn eine Feldbeeinflussung durch einen Materialniederschlag auf der Meßelektrode hervorgerufen wird, entsteht an der Meßelektrode ein Meßsignal, das in dem angeschlossenen Auswerteschaltkreis zur Bestimmung der Niederschlagsdicke auf der Meßelektrode hinsichtlich der Schichtdicke ausgewertet wird.

Bei einem vorteilhaften Ausführungsbeispiel der Erfindung sind die felderzeugenden Elektroden ringförmig ausgebildet, während die Meßelektrode zwischen den beiden ringförmigen Elektroden im rechten Winkel zu deren Längsachsen angeordnet ist. Auf diese Weise kann das Beschichtungsmaterial durch die Öffnung in den felderzeugenden Elektroden auf eine Seite der Meßelektrode gelangen.

Zweckmäßig ist es, wenn die Meßelektrode auf den beiden Seiten einer Keramikscheibe ausgebildet ist und aus einer Goldschicht besteht, die als Unterlage eine Haftschicht aus Nickel aufweist. Zur Entkopplung sind zwischen den Keramikringen und der Keramikscheibe auf beiden Seiten der Keramikscheibe Metallringe vorgesehen, die mit Signalmasse verbunden sind.

Weitere zweckmäßige Ausgestaltungen sind in den abhängigen Ansprüchen gekennzeichnet.

In der Zeichnung ist ein Ausführungsbeispiel der Erfindung dargestellt. Es zeigen:

Fig. 1 die Referenzsonde der Vorrichtung im axialen Schnitt,

Fig. 2 einen Ausschnitt der Referenzsonde in perspektivischer Ansicht,

Fig. 3 die auf einer Keramikscheibe aufgebrachte Meßelektrode und die auf Keramikringen aufgebrachten felderzeugenden Elektroden in perspektivischen Ansichten und

Fig. 4 die an die Referenzsonde angeschlossene Auswerteschaltung.

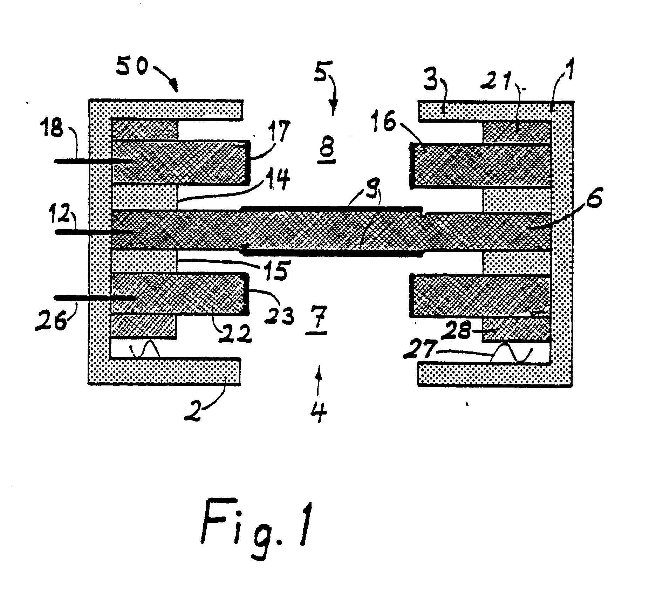

In Fig. 1 erkennt man eine im wesentlichen rohrförmige Referenzsonde 50, die zur Messung der Schichtstärke nicht am zu vermessenden Trägermaterial selbst angeordnet ist, sondern ein Referenzsystem darstellt, das dem für die Beschichtung des Trägermaterials verwendeten Teilchenstrahl ebenfalls ausgesetzt ist, wobei die unterschiedlichen Orte des Trägermaterials und der Referenzsonde bei der Auswertung der in der Referenzsonde 50 gemessenen Schichtdicken rechnerisch berücksichtigt werden.

Die in Fig. 1 dargestellte Referenzsonde 50 verfügt über ein im wesentlichen rohrförmiges Metallgehäuse 1, das an seinen Enden in Flanschteile 2 und 3 übergeht. Das Metallgehäuse 1 hat beispielsweise einen Durchmesser von ca. 20 mm und eine axiale Länge von ebenfalls etwa 20 mm.

Sowohl im Flanschteil 2 als auch im Flanschteil 3 sind jeweils Einlaßöffnungen 4 bzw. 5 vorgesehen. Der von dem Metallgehäuse 1 umfaßte Raum wird durch eine Keramikscheibe 6 in zwei Innenräume 7 und 8 aufgeteilt, die jeweils über die Einlaßöffnungen 4 und 5 zugänglich sind.

Die Keramikscheibe 6 ist im mittleren Bereich beidseitig mit einer scheibenförmigen Metallschicht bedeckt, die beispielsweise aus einer 0,1 μm dicken Goldschicht besteht, die auf Nickel als Haftschicht aufgebracht ist. Die beiden Metallschichten bilden eine beidseitige Meßelektrode 9 und sind elektrisch in der in Fig. 1 dargestellten Weise durch eine Brücke 10 miteinander verbunden, die aus einer in einer Ausnehmung 11 in der Keramikscheibe 6 versenkten Metallbeschichtung besteht.

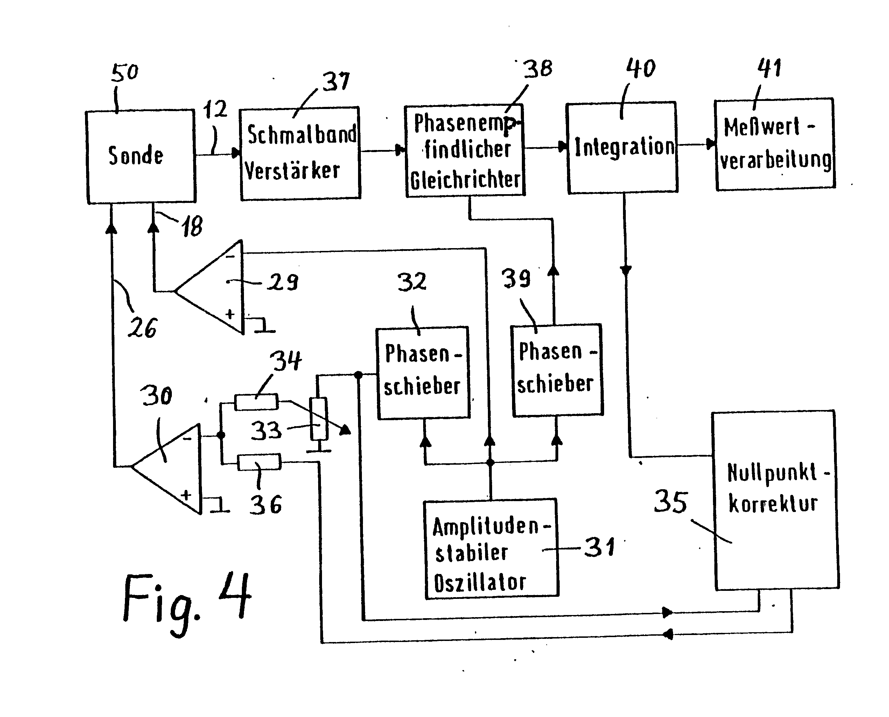

Die Meßelektrode 9 ist an eine in Fig. 1 dargestellte Zuleitung 12 angeschlossen, die in einem Loch 13 in der Brücke 10 endet und dort elektrisch leitend mit der Meßelektrode 9 verbunden ist. Das andere Ende der Zuleitung 12 ist, wie man in Fig. 4 erkennt, mit dem Eingang eines Schmalbandverstärkers 37 verbunden.

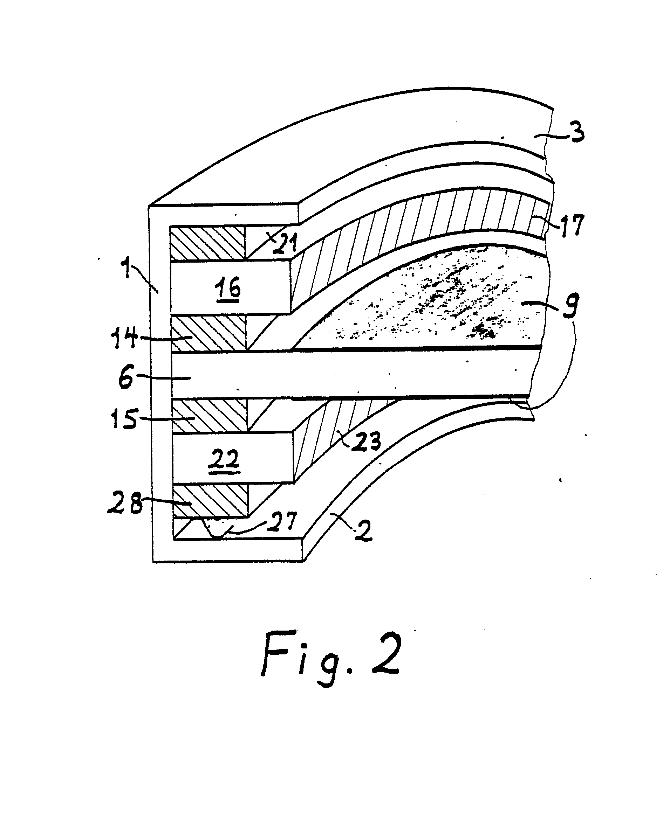

Wie in den Figuren 1 und 2 gezeigt ist, liegt die Keramikscheibe 6 gegen einen oberen Metallring 14 und einen unteren Metallring 15 an, die mit der Masse elektrisch verbunden sind. Diese Metallringe 14, 15 dienen einerseits als Massebarrieren zwischen den Keramikteilen und andererseits als Abstandsringe.

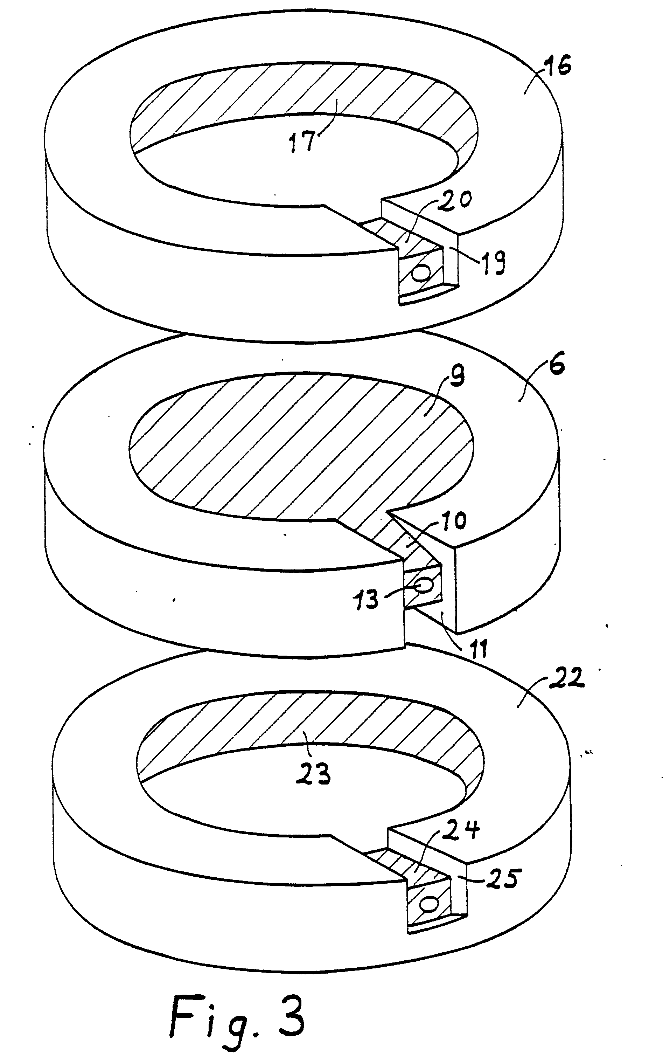

Der obere Metallring 14 ist gegen einen oberen Keramikring 16 abgestützt, dessen Form in Fig. 3 gut zu erkennen ist. Entlang dem Innenumfang des oberen Keramikrings 16 ist eine erste ringförmige Elektrode 17 ausgebildet, die über eine Zuleitung 18 mit einer Wechselspannung beaufschlagt wird, so daß die Elektrode 17 als felderzeugende Elektrode im Bereich des Innenraums 8 wirksam werden kann, der als Referenzteil dient, wenn über die Einlaßöffnung 4 ein Dampfstrahl oder ein sonstiger Teilchenstrahl in den Innenraum 7 als Meßteil eintritt.

Die Zuleitung 18 ist mit der Elektrode 17 über ein in einer Ausnehmung 19 versenktes Anschlußstück 20 verbunden. Der obere Keramikring 16 liegt mit seiner Oberseite gegen einen Abstandsring 21 aus Keramik oder Metall an, so daß Kurzschlüsse zwischen der Elektrode 17 und dem Flanschteil 3 nicht zu befürchten sind.

Ähnlich dem in Fig. 1 oberhalb der Keramikscheibe 6 ausgebildeten Referenzteil ist unterhalb der Keramikscheibe 5 der Meßteil ausgebildet. Der untere Metallring 15 liegt gegen einen unteren Keramikring 22 an, der mit einer zweiten ringförmigen Elektrode 23 entlang seinem Innenumfang versehen ist. Die zweite ringförmige Elektrode 23 ist elektrisch mit einem Anschlußstück 24 verbunden, das in Fig. 3 erkennbar ist und in einer Ausnehmung 25 im Keramikring 22 versenkt ist. Über eine Zuleitung 26, die in Fig. 1 und in Fig. 4 dargestellt ist, erhält die zweite ringförmige Elektrode 23 eine Wechselspannung, die gegenüber der auf der ersten ringförmigen Elektrode 17 angelegten Wechselspannung um 180° phasenverschoben ist und deren Spannung mit Hilfe der in Fig. 4 dargestellten Schaltung so eingestellt werden kann, daß insbesondere bei Meßbeginn am Ort der Meßelektrode 9 das Potential Null herrscht.

Gegen den unteren Keramikring 22 ist mit Hilfe eines Sprengrings 27 ein Abstandsring 28 angedrückt, der aus Metall oder Keramik bestehen kann.

Die in Fig. 1 ganz und in, den Figuren 2 und 3 teilweise dargestellte Referenzsonde 50 wird bei der Durchführung einer kontinuierlichen Messung eines Materialniederschlages, insbesondere einer Aufdampfdicke, in der in Fig. 4 dargestellten Weise elektrisch geschaltet. Mechanisch wird dabei das Metallgehäuse 1 so ausgerichtet, daß z. B. der Innenraum 7 dem Dampfstrahl oder dergleichen ausgesetzt ist und als Meßteil dient, während der Innenraum 8 dann als Referenzteil dient und im Schatten des Dampfstrahls oder dergleichen liegt.

Um die erste ringförmige Elektrode 17 mit einer Wechselspannung und die zweite ringförmige Elektrode 23 mit einer gegenphasigen Wechselspannung zu versorgen, sind diese über die Zuleitungen 18 und 26 mit den Ausgängen von Verstärkern 29 und 30 verbunden. Während der Verstärker 29 eingangsseitig unmittelbar über einen amplitudenstabilen Oszillator 31 gespeist ist, wird der Verstärker 30 mit einer um 180° phasenverschobenen Spannung gespeist, deren Amplitude variabel ist. Die Ausgangsspannung des Oszillators 31 gelangt daher über einen Phasenschieber 32 zur Erzeugung einer Phasenverschiebung von 180°, über ein Potentiometer 33 und einen Widerstand 34 zum Eingang des Verstärkers 30. Damit die Eingangsspannung des Verstärkers 30 nicht nur manuell mit Hilfe des Potentiometers 33 verstellbar ist, ist die Ausgangsspannung des Phasenschiebers 32 zusätzlich über eine Nullpunktskorrekturschaltung 35 und einen Widerstand 36 mit dem Eingang des Verstärkers 30 verbunden. Mit Hilfe der Nullpunktskorrekturschaltung 35 kann die Spannung auf der zweiten ringförmigen Elektrode 23 automatisch so nachgestellt werden, daß auf der Meßelektrode 9 nach einer Störung des Gleichgewichtes infolge der Ablagerung einer leitenden oder nichtleitenden Schicht auf der Meßelektrode 9 wiederum das Potential Null herrscht. Außerdem dient die Nullpunktskorrekturschaltung 35 zur Kompensation von mechanischen Änderungen der Elektrodenanordnung und Langzeitdriften der Elektronik.

Wenn zu Beginn eines Meßvorgangs noch kein Materialniederschlag auf der zum Innenraum 7 weisenden Seite der Meßelektrode 9 vorhanden ist und die oben erörterte Nullpunktseinstellung stattgefunden hat, liegt die Meßelektrode 9 auf dem Potential Null, so daß über die Zuleitung 12, die mit dem Eingang eines Schmalbandverstärkers 37 verbunden ist, kein Strom fließt. Wenn jedoch infolge einer Störung des Gleichgewichts durch die Ablagerung eines Materialniederschlags auf der Meßelektrode 9 ein Strom in der Zuleitung 12 erzeugt wird, erfolgt mit Hilfe des Verstärkers 37, der auf die Frequenz des Oszillators 31 abgestimmt ist, eine sehr große Verstärkung des Eingangssignals, so daß bereits äußerst geringe Schichtdicken erfaßt werden können, die linear bei leitenden Niederschlägen bereits erfaßt werden können, wenn die Schichtdicke lediglich 0,1 μm beträgt oder sich bei dem hier erörterten Ausführungsbeispiel bis zur oberen Meßgrenze von 1 mm Schichtdicke um 0,1 μm ändert. Nichtleitende Niederschläge können ebenfalls erfaßt werden, wobei der hier nichtlineare Zusammenhang zwischen Schichtdicke und Meßsignal durch Eichkurven z. B. mittels eines Mikroprozessors korrigiert werden kann.

Wie in Fig. 4 weiter zu erkennen ist, ist der Ausgang des Verstärkers 37 mit einem phasenempfindlichen Gleichrichter 38 verbunden, der über einen Phasenschieber 39 ein Referenzsignal erhält und ein nach Betrag und Phase richtungsempfindliches Ausgangssignal liefert.

Das Ausgangssignal des Gleichrichters 38 speist eine Integrationsstufe 40, in der ein Meßsignal erzeugt wird, dessen Größe von der Dicke des Materialniederschlages auf der Meßelektrode 9 abhängt, wobei bei leitenden Substanzen ein linearer Zusammenhang zwischen der Schichtdicke und dem Meßwert besteht. Die Integrationsstufe 40 ist einerseits mit einer Meßwertverarbeitungsstufe 41 und andererseits mit dem Nullpunktkorrekturschaltkreis 35 verbunden.

Die Verbindung der Referenzsonde geschieht bis zur Durchführung des Tanks, in dem die Beschichtung erfolgt, mittels Semirigid-Koaxialkabel und von dort über gewöhnliche Koaxialkabel bis zu der in Fig. 4 dargestellten Schaltung.

**Patentansprüche**

1. Vorrichtung zur kontinuierlichen Messung der Dicke eines mit Hilfe einer Beschichtungsanlage auf einem Trägermaterial erzeugten Materialniederschlags durch Bestimmung der Ablagerungsdicke auf einer mit dem Eingang eines Auswerteschaltkreises (29 bis 41) gekoppelten, zwei felderzeugende Elektroden (17, 23) aufweisenden Referenzsonde (50), die in der Beschichtungsanlage in der Nähe des Trägermaterials in einem Gehäuse (1) mit wenigstens einer als Blendenöffnung dienenden Einlaßöffnung (4, 5) angeordnet und mit einer Wechselspannung beaufschlagt ist, dadurch gekennzeichnet, daß die Referenzsonde (50) eine das auszuwertende Signal (12) auskoppelnde, im Feld der beiden felderzeugenden Elektroden (17, 23) angeordnete starre Meßelektrode (9) aufweist und daß die zwei felderzeugenden Elektroden (17, 23) mit gegeneinander um 180° phasenverschobenen Wechselspannungen beaufschlagt sind, deren Amplituden wenigstens bei Meßbeginn durch den im Auswerteschaltkreis (29 bis 41) enthaltenen Ansteuerteil (29 bis 36) für die felderzeugenden Elektroden (17, 23) so einstellbar sind, daß die in der Meßelektrode (9) durch die beiden felderzeugenden Elektroden (17, 23) bewirkten Ströme gegenseitig kompensiert sind.

2. Vorrichtung nach Anspruch 1, dadurch gekennzeichnet, daß die felderzeugenden Elektroden (17, 23) ringförmig ausgebildet sind.

3. Vorrichtung nach Anspruch 2, dadurch gekennzeichnet, daß die Meßelektrode (9) zwischen den beiden ringförmigen Elektroden (17, 23) im rechten Winkel zu deren Längsachsen angeordnet ist.

4. Vorrichtung nach Anspruch 3, dadurch gekennzeichnet, daß die Meßelektrode (9) auf den beiden Seiten einer Keramikscheibe (6) ausgebildet ist.

5. Vorrichtung nach Anspruch 4, dadurch gekennzeichnet, daß die Keramikscheibe (6) im mittleren Bereich auf beiden Seiten mit einer Haftschicht und einer darüberliegenden dünnen, leitenden Schicht versehen ist.

6. Vorrichtung nach einem der Ansprüche 2 bis 5, dadurch gekennzeichnet, daß die felderzeugenden Elektroden (17, 23) entlang dem Innenumfang von Keramikringen (16, 22) ausgebildet sind.

7. Vorrichtung nach einem der vorstehenden Ansprüche, dadurch gekennzeichnet, daß zwischen der beidseitig die Meßelektrode (9) tragenden Keramikscheibe (6) und den die felderzeugenden Elektroden (17, 23) tragenden Keramikringen (16, 22) Abstandsringe (14, 15) angeordnet sind.

8 Vorrichtung nach Anspruch 4, 6 oder 7, dadurch gekennzeichnet, daß die Keramikscheibe (6), die Keramikringe (16, 22) und die Abstandsringe (14, 15) axial fluchtend in einem Metallgehäuse (1) angeordnet sind, das auf wenigstens einer Seite, fluchtend mit dem Innenraum (8, 7) der Keramikringe (16, 22), die Einlaßöffnung (4, 5) aufweist.

9. Vorrichtung nach Anspruch 7, dadurch gekennzeichnet, daß die Abstandsringe (14, 15) metallisch leitend sind.

10. Vorrichtung nach Anspruch 8 oder 9, dadurch gekennzeichnet, daß das Metallgehäuse (1) rohrförmig ist und die äußeren axialen Seiten der Keramikringe (16, 22) gegen nach innen weisende Flanschteile (3, 2) des Metallgehäuses (1) abgestützt sind.

### Claims

1. Apparatus for continuously measuring the thickness of a material deposit which is produced on a carrier material by means of a coating installation by determining the thickness of deposit on a reference probe which is coupled to the input of an evaluation circuit and which has two field-generating electrodes and which is arranged in a coating installation in the vicinity of the carrier material in a housing with at least one inlet opening serving as an aperture opening and which is supplied with an ac voltage, characterised in that the reference probe (50) has a rigid measuring electrode (9) which couples out the signal (12) to be evaluated and which is arranged in the field of the two field-generating electrodes (17, 23) and that the two field-generating electrodes (17, 23) are supplied with ac voltages which are phase-shifted relative to each other through 180° and whose amplitudes are so set at least at the beginning of the measurement operation by the actuating portion (29 to 36) for the field-generating electrodes (17, 23) of the evaluation circuit (29 to 41) that the currents produced in the measuring electrode (9) by the two field-generating electrodes (17, 23) are mutually compensated.

2. Apparatus according to claim 1 characterised in that the field-generating electrodes (17, 23) are of an annular configuration.

3. Apparatus according to claim 2 characterised in that the measuring electrode (9) is arranged between the two annular electrodes (17, 23) at a right angle to the longitudinal axes thereof.

4. Apparatus according to claim 3 characterised in that the measuring electrode (9) is provided on the two sides of a ceramic disc (6).

5. Apparatus according to claim 4 characterised in that the ceramic disc (6) is provided in the middle region and on both sides with a bonding layer and a thin conducting layer.

6. Apparatus according to one of claims 2 to 5 characterised in that the field-generating electrodes (17, 23) are provided along the inside periphery of ceramic rings (16, 22).

7. Apparatus according to one of the preceding claims characterised in that spacer rings (14, 15) are arranged between the ceramic disc (6) carrying the measuring electrode (9) on the two sides, and the ceramic rings (16, 22) carrying the field-generating electrodes (17, 23).

8. Apparatus according to claim 4, claim 6 or claim 7 characterised in that the ceramic disc (6), the ceramic rings (16, 22) and the spacer rings (14, 15) are arranged in axially aligned relationship in a metal housing (1) which on at least one side has an inlet opening (4, 5) aligned with the internal space (8, 7) of the ceramic rings (16, 22).

9. Apparatus according to claim 7 characterised in that the spacer rings (14, 15) are metallically conducting.

10. Apparatus according to claim 8 or claim 9 characterised in that the metal housing (1) is tubular and the outer axial sides of the ceramic rings (16, 22) are supported against inwardly facing flange portions (3, 2) of the metal housing (1).

### Revendications

1. Installation de mesure continue de l'épaisseur d'un dépôt de matériau produit à l'aide d'une installation d'enduction sur un matériau de support, par détermination de l'épaisseur de sédimentation sur une électrode de référence reliée à l'entrée d'un circuit d'évaluation, comportant deux électrodes génératrices de champ, électrode de référence disposée dans un dispositif d'enduction à proximité du matériau de support dans un boîtier avec au moins une ouverture d'entrée servant d'ouverture d'anode et alimentée par une tension alternative, caractérisée en ce que la sonde de référence (50) comporte une sonde de mesure (9) montée fixe dans le champ des deux électrodes génératrices de champ (17, 23), découplant le signal (12) à évaluer, et que les deux électrodes génératrices de champ (17, 23) subissent l'action de tensions alternatives déphasées de 180° entre elles, dont les amplitudes au moins au début de la mesure peuvent être fixées par l'ensemble de commande (29 à 36) des électrodes génératrices de champ (17, 23) du circuit d'évaluation (29 à 41), de manière telle que les courants atteignant l'électrode de mesure (9) par les deux électrodes (17, 23) génératrices de champ soient compensées réciproquement.

2. Installation selon la revendication 1, caractérisée en ce que les électrodes génératrices de champ (17, 23) sont de configuration annulaire.

3. Installation selon la revendication 2, caractérisée en ce que l'électrode de mesure (9) est disposée entre les deux électrodes annulaires (17, 23) à angle droit par rapport à leur axe longitudinal.

4. Installation selon la revendication 3, caractérisée en ce que l'électrode de mesure (9) est conformée sur les deux côtés d'un disque de céramique (6).

5. Installation selon la revendication 4, caractérisée en ce que le disque de céramique (6) est muni dans sa zone médiane, des deux côtés, d'une couche adhésive et d'une couche mince conductrice.

6. Installation selon l'une quelconque des revendications 2 à 5, caractérisée en ce que les électrodes (17, 23) génératrices de champ sont conformées le long du périmètre intérieur d'anneaux céramiques (16, 22).

7. Installation selon l'une quelconque des revendications précédentes, caractérisée en ce que des anneaux d'espacement (14, 15) sont disposés entre le disque de céramique (6) supportant les électrodes de mesure bilatérales (9) et les anneaux céramiques (16,22) supportant les électrodes génératrices de champ (17, 23).

8. Installation selon l'une des revendications 4, 6 ou 7, caractérisée en ce que le disque de céramique (6), les anneaux de céramique (16, 22) et les anneaux d'espacement (14, 15) sont montés en alignement axial dans un boîtier métallique (1), qui présente sur au moins un côté une ouverture d'entrée (4, 5) en alignement avec l'espace intérieur (8, 7) des anneaux de céramique (16, 22).

9. Installation selon la revendication 7, caractérisée en ce que les anneaux d'espacement (14, 15) sont en métal conducteur.

10. Installation selon l'une des revendications 8 ou 9, caractérisée en ce que le boîtier métallique (1) est tubulaire et que les côtés extérieurs axiaux des anneaux céramiques (16, 22) s'appuient contre des sections de flasques (3, 2) du boîtier métallique (1) disposées vers l'intérieur.

Fig. 1

Fig. 2

Fig. 3

Fig. 4

0 167 606